# EUROPÄISCHE PATENTSCHRIFT

(11) **EP 3 140 245 B1**
(45) Veröffentlichungstag und Bekanntmachung des Hinweises auf die Patenterteilung: **18.04.2018**
(21) Anmeldenummer: 15719195.8
(22) Anmeldetag: 23.04.2015
(51) Int. Cl.: B81B 7/02

(54) **SENSORBAUELEMENT MIT ZWEI SENSORFUNKTIONEN**
SENSOR COMPONENT HAVING TWO SENSOR FUNCTIONS
COMPOSANT DE CAPTEUR À DEUX FONCTIONS DE DÉTECTION

(30) Priorität: 05.05.2014 DE 102014106220
(43) Veröffentlichungstag der Anmeldung: 15.03.2017
(73) Patentinhaber: TDK Corporation, Tokyo 108-0023 (JP)
(72) Erfinder: PAHL, Wolfgang, 81379 München (DE)
(74) Vertreter: Epping - Hermann - Fischer
(86) Internationale Anmeldenummer: PCT/EP2015/058814
(87) Internationale Veröffentlichungsnummer: WO 2015/169615

(56) Entgegenhaltungen:
- DE-A1-102006 046 292
- DE-A1-102008 025 599
- DE-A1-102010 006 132
- DE-A1-102010 007 605

## Beschreibung

Mikroelektronische Sensoren z.B. zur Erfassung von Druck und Feuchte der Umgebungsluft sind bisher nur als separate Komponenten bekannt. In aller Regel dient zur Druckmessung ein MEMS Chip, auf dem piezoresistive Widerstände die Durchbiegung einer Membran über einem Referenzvolumen erfassen.

Die Messung der relativen Luftfeuchte erfolgt häufig dadurch, dass ein Polymer als Dielektrikum in einem Kondensator eingesetzt wird, welches bei Wassereinlagerung eine Änderung seiner dielektrischen Eigenschaften aufweist. Die Änderungen werden dann als Funktion der Luftfeuchtigkeit ausgewertet.

Die Messung der Temperatur erfolgt häufig mit Widerstandssensoren, die Heiß- oder Kaltleitereigenschaften aufweisen können. Andere Temperatursensoren nutzen die temperaturabhängige Resonanz von Resonatoren oder eine beliebige andere temperaturabhängige physikalische Größe, vorzugsweise eine elektrische Größe.

Es gibt Anwendungen, bei denen Informationen mehrerer Sensoren zur selben Zeit bzw. am selben Ort erforderlich sind. Die gleichzeitige Bestimmung von Druck, Luftfeuchte und gegebenenfalls der Temperatur ist z.B. zur Erfassung des aktuellen Wetters, für die Wetterprognose, für die Erfassung der Luftqualität oder auch technisch z.B. zur Bestimmung der Luftdichte in Festplatten sehr hoher Kapazität zur Stabilisierung des Magnetkopfabstandes erforderlich.

Aus der DE 102008025599 A1 ist eine Sensoranordnung bekannt, bei der ein erster, vorzugsweise ein MEMS Sensor am Boden eines Hohlraumgehäuses und ein zweiter, vorzugsweise Halbleitersensor, am Deckel des Hohlraumgehäuses befestigt ist.

Aus der DE 102010006132 A1 ist ein MEMS Bauelement bekannt, bei dem ein ASIC einen Teil eines Gehäuses für den MEMS Chip ausbildet.

Aufgabe der vorliegenden Erfindung ist, ein Sensorbauelement anzugeben, das in kostengünstiger Weise mehrere Sensorfunktionen zur Verfügung stellt. Eine weitere Aufgabe besteht in der Angabe eines Gehäuses mit minimalen Abmessungen zur Aufnahme der Sensorelemente sowie ggfs. erforderlicher Auswerteschaltkreise.

Diese Aufgabe wird erfindungsgemäß durch ein Sensorbauelement nach Anspruch 1 gelöst. Vorteilhafte Ausgestaltungen sind weiteren Ansprüchen zu entnehmen.

Das erfindungsgemäße Sensorbauelement umfasst ein erstes Sensor¬element, welches als MEMS-Sensor, zum Beispiel in Chipbauweise, ausgebildet ist. Der üblicherweise stress-empfind¬liche MEMS-Sensor wird entkoppelt von mechanischen Spannungen in einem Hohlraum angeordnet, der durch eine Gehäusekavität gebildet ist.

Ein zweites Sensorelement ist als ein ASIC, also ein Chip mit integriertem Schaltkreis und einer aktiven Sensorfläche aus¬ge¬bildet. Das zweite Sensorelement ist auf, im oder unter dem Deckel angeordnet, mit dem die Gehäusekavität, also der Hohlraum für das Sensorbauelement, verschlossen ist.

Das Sensorbauelement weist elektrische Außenkontakte auf, die an einer Außenfläche des Gehäuses angeordnet sind. Das Gehäuse selbst weist ein Boden¬element, ein rahmenförmig ausgebildetes Wandelement und einen Deckel auf, die zusammen den genannten Hohlraum einschließen.

Um eine Sensorfunktion im Gehäuse zu ermöglichen, ist ein Zugang vom im Gehäuseinneren angeordneten erste Sensorelement und gegebenenfalls auch vom zweiten Sensorelelement zur Umgebungsluft erforderlich. Dazu weist der Hohlraum beziehungsweise das Gehäuse in Deckel, Boden- oder Wandelement zumindest eine Öffnung auf.

Durch die enge räumliche Nähe der beiden Sensorelemente können beide Sensorfunktionen, also die Bestimmung der beiden physikalischen Parameter am selben Ort vorgenommen werden. Dies ist insbesondere für bestimmte Kombinationen von Parametern von Vorteil, deren Messwerte Abhängigkeiten voneinander aufweisen, so dass deren Messung in kurzen räumlichen und zeitlichen Abständen mit den nahe benachbarten Sensorelementen exakt möglich wird.

Die Anordnung beider Sensorelemente innerhalb eines Gehäuses oder an einem Gehäuse produziert nur geringe Totvolumina, so dass kurze Ansprechzeiten beider Sensorelemente gewährleistet sind. Da zudem ein Gehäuse für das zweite Sensorelement eingespart wird, werden die beiden Sensorfunktionen auch durch ein Sensorbauelement mit minimalen Außenabmessungen zur Verfügung gestellt.

Der MEMS-Sensor ist verspannungsfrei auf Federkontaktelementen montiert, die zum Einen Kontaktflächen des MEMS-Sensors mit inneren Anschlüssen auf der Innenseite des Bodenelements verbinden und zum Anderen eine verspannungsfreie Montage des MEMS-Sensors innerhalb des Gehäuses ermöglichen. Durch die elastische Aufhängung ist der MEMS-Sensor zudem gut gegen mechanische Belastung wie beispielsweise gegen Stoß geschützt. Auch schnelle oder starke Temperaturwechsel können mit den Federkontaktelementen ausgeglichen werden, so dass der MEMS-Sensor unabhängig von der Außentemperatur fehlerfrei arbeiten kann. Das Stressproblem ist allein deshalb zu beachten, weil die momentan erreichbare Sensorauflösung einer Membran¬auslenkung im sub-Nanometerbereich entspricht. Eine zu starre Montage, wie sie beispielsweise durch eine Bumpverbindung auf einem starren Substrat erhalten wird, bei der über die Lotbumps viel größere Kräfte auf das als Sensor-Chip ausgebildete Sensorelement übertragen werden als beispielsweise über einem weichen Klebstoff und Drahtbondanschlüsse. Dementsprechend sensibel reagieren MEMS-Chips auf Verspannungen. Dies wird bei der Erfindung vermieden.

Die Federkontaktelemente können als längliche Blattfedern ausgebildet sein, die mit einem Ende am Boden des Gehäuses und mit dem anderen Ende beabstandet vom Boden mit dem MEMS-Sensor verbunden sind. Die Federkontaktelemente können einfach oder mehrfach abgewinkelt, gebogen oder auch spiralförmig ausgebildet sein.

Das Sensorbauelement weist zumindest einen ASIC auf, der die Sensorfunktion des zweiten Sensorelements unterstützt und einen Ausgabewert generiert. Der zweite Sensor kann vollständig auf oder in dem ASIC realisiert sein. Der ASIC kann dann abhängig von den Größenverhältnissen wahlweise deckel- oder bodenseitig untergebracht werden.

Der ASIC ist insbesondere in Flipchip-Technologie montiert. In einer Ausgestaltung kann dieser ASIC auch dazu genutzt werden, die Sensorfunktion des ersten Sensorelements zu unterstützen und auch für diesen einen Ausgabewert generieren. Durch die Integration innerhalb eines Halbleiterbauelementes kann das erforderliche Volumen für das Sensorbauelement weiter minimiert werden. Bei Verwendung nur eines Halbleiterbauelements, also nur eines ASICs für beide Sensorelemente können verschiedene Schaltkreise des ASIC für beide Sensorelemente gemeinsam genutzt werden. Dadurch werden weitere Synergieeffekte generiert.

In einer Ausführungsform ist das erste Sensorelement als MEMS-Drucksensor ausgebildet.

In einer Ausführungsform der Erfindung ist das zweite Sensorelement als Feuchtesensor ausgebildet.

In einer Ausführungsform der Erfindung ist das zweite Sensorelement als Temperatursensor ausgebildet.

In einer weiteren Ausführungsform der Erfindung ist das zweite Sensorelement zur quasi gleichzeitigen Bestimmung von Feuchte und Temperatur ausgebildet. Dann weist das Sensorbauelement drei Sensorfunktionen auf und kann parallel entsprechende Messwerte für die drei Parameter liefern. Diese beiden Funktionen lassen sich auf einer gemeinsamen aktiven Sensorfläche realisieren, auf der dann gegebenenfalls zwei unabhängige Messelemente für die beiden Sensorfunktionen ausgebildet sind, beispielsweise eine Widerstandsstrecke zur Bestimmung der Temperatur sowie ein Kondensator zur Bestimmung einer feuchtigkeitsabhängigen dielektrischen Konstante eines als Dielektrikum des Kondensators genutzten Materials. Der Temperatursensor kann auch auf einem Halbleitereffekt basieren und daher unter der Oberfläche im Inneren des ASIC realisiert sein.

Für genaue Messungen der beiden Parameter Druck und Feuchtigkeit ist auch eine präzise Temperaturmessung nahe am ersten Sensorelement notwendig, die aufgrund der Integration dann nur einmal realisiert werden muss.
In einer bevorzugten Ausführungsform ist der Deckel des Gehäuses als Leiterplatte ausgebildet, in der eine integrierte Verschaltung realisiert ist. Die Verschaltung ist mit dem zweiten Sensorelement verbunden. Der ASIC ist außerdem mit den Außenkontakten an der Unterseite des Bodenelements verbunden. Die elektrische Verbindung erfolgt über die Leiterplatte, verläuft dann innerhalb des Wandelements und wird schließlich durch das Bodenelement hindurch zu den elektrischen Außenkontakten geführt.

Die elektrischen Verbindungen sind in den unterschiedlichen Gehäuseteilen vorgefertigt und werden bei der Montage der Einzelteile bzw. beim Schließen des Hohlraums des Gehäuses elektrisch miteinander kontaktiert. Diese Kontaktierung kann durch Verlöten erfolgen. Möglich ist es jedoch auch, die elektrische und mechanische Verbindung durch Verwendung elektrisch leitfähiger Klebstoffe zu erzeugen.

In einer Ausführungsform weist das Sensorbauelement im oben angeordneten Deckel eine Öffnung auf. Die aktive Sensorfläche des zweiten Sensorelements ist unterhalb dieser Öffnung angeordnet, so dass die aktive Sensorfläche freien und nahezu ungehinderten Zugang zur Umgebungsluft besitzt. Dies ist von Vorteil, da das zweite Sensorelement auf einen besonders guten und schnellen Luftaustausch angewiesen ist, um aktuelle bzw. korrekte Messwerte zu liefern.

In einer Ausführungsform ist das zweite Sensorelement so angeordnet und montiert, dass es die Öffnung des Deckels von unten beziehungsweise von innen verschließt. Dies kann dadurch erfolgen, dass das zweite Sensorelement mit einem Klebstoff von unten auf den Deckel geklebt ist. Möglich ist es auch, das zweite Sensorelement im Abstand unten am Deckel zu befestigen und anschließend den Raum zwischen der Ober¬seite des zweiten Sensorelements und der Unterseite des Deckels zumindest entlang der Kanten des zweiten Sensor¬elements mit einer Unterfüllmasse aufzufüllen und abzu¬dichten.

Ein Abstand zwischen zweitem Sensorelement und Deckel kann beispielsweise über elektrische Verbindungselemente erzeugt werden, die als Bumps oder Lotverbindungen ausgebildet sind. In beiden Fällen ist die Abdichtung, also der Klebstoff oder die Unterfüllmasse so aufgebracht, dass die aktive Sensorfläche frei davon bleibt. Im Fall einer flüssig verarbeitbaren Unterfüllmasse kann dies dadurch gewährleistet werden, dass die Unterfüllmasse so appliziert wird, dass sie von Kapillarkräften im Zwischenraum zwischen Deckel und zweitem Sensorelement verteilt werden, die ja unterhalb der Öffnung, also oberhalb der aktiven Sensor¬fläche nicht existieren, so dass die aktive Sensor-ifläche frei von Unterfüllmasse bleibt. Bei Verwendung von Klebstoff wird entweder der Klebstoff strukturiert auf den ASIC beziehungsweise das zweite Sensorelement aufgetragen. Möglich ist es auch, den Klebstoff auf der Unterseite des Deckels aufzutragen.

Im Falle einer Verklebung wird die elektrische Verbindung von ASIC und Leiterplatte über Bonddrähte hergestellt. Möglich ist es auch, einen elektrisch anisotrop leitenden Klebstoff einzusetzen, der eine elektrische Leitung nur auf dem kürzesten Weg vertikal durch die Kleberschicht ermöglicht.

Das Gehäuse weist eine Durchführung auf, die das Innere des Gehäuses, beziehungsweise den Hohlraum mit der Umgebung außerhalb des Gehäuses verbindet. Dadurch wird auch eine direkte Verbindung des MEMS-Sensors mit der Umgebung gewährleistet. Der Druckausgleich vollzieht sich auch bei kleinen Öffnungen und trotz des Innenvolumens sehr schnell. Der Zugang zur Umgebung ermöglicht auch die Bestimmung der physikalischen Parameter in der Umgebung des Sensorbauelements durch Bestimmung innerhalb des Hohlraums.

Vorteilhaft wird das erste als Drucksensor ausgebildete Sensorelement mit geeigneten Schutzmaßnahmen (z.B. durch Ausbilden der Öffnung in Form langer, dünner Röhren, durch dazwischen angeordnete Membranen oder hydrophobe Filter etc.) vor Feuchtigkeit in der Umgebung des Sensorbauelements geschützt werden. Dem kommt entgegen, daß der Druckausgleich auch bei relativ geringen Strömungsquerschnitten sowie zusätzlichen Strömungswiderständen der genannten Elemente hinreichend schnell erfolgen kann.

Die Durchführung kann eine Bohrung sein, die durch den Deckel, das Bodenelement oder das Wandelement des Gehäuses geführt ist.

In einer Ausführungsform ist der Deckel so im Abstand auf dem Wandelement befestigt, dass zwischen Deckel und Wandelement eine Durchführung ausgebildet wird, die bereits einen Luftaustausch mit der Umgebung und damit eine Bestimmung von Umgebungsparametern im Innern des Hohlraums ermöglicht.

In einer Ausführungsform der Erfindung ist das Bodenelement ebenfalls als Leiterplatte ausgebildet. Die Leiterplatte weist zumindest eine innen liegende Metallisierungsebene auf, die über Durchkontaktierungen mit den inneren Anschluss¬flächen auf der Innenseite des Bodenelements sowie mit den elektrischen Außenkontakten auf der Unterseite des Bodenelements verbunden ist.

In einer Ausführungsform ist das zweite Sensorelement auf der Unterseite des Deckels montiert und mit einer Folie gegen den Deckel abgedichtet. Die Folie ist dabei - von innen betrachtet - über dem zweiten Sensorelement aufgebracht und schließt rund um das zweite Sensorelement allseits mit dem Deckel ab.

In einer Ausführungsform weist das Gehäuse eine Öffnung auf, die oberhalb des zweiten Sensorelements durch den Deckel geführt ist. Das zweite Sensorelement ist unten am Deckel im Abstand zu diesem montiert, beispielsweise über Lötkontakte, so dass ein Spalt zwischen Deckel und zweitem Sensorelement verbleibt. Über diesen Spalt ist ein Luftzutritt zum Hohlraum und damit auch zum zweiten Sensorelement geschaffen, der eine weitere Öffnung oder Durchführung für die erste Sensor¬funktion überflüssig macht. Umgekehrt ist es auch möglich, eine Durchführung im Bereich des ersten Sensorelements insbesondere durch das Bodenelement vorzusehen und so einen gemeinsamen Luftzulass ins Innere des Gehäuses für erstes und zweites Sensorelement auszubilden.

Auch das erste Sensorelement kann in herkömmlicher Weise auf dem Bodenelement befestigt sein, beispielsweise durch direktes Auflöten, beispielsweise in Flipchip-Bauweise. Möglich ist es auch, das erste Sensorelement innen auf das Bodenelement aufzukleben und mittels Bonddrähten mit entsprechenden inneren Anschlussflächen des Bodenelements zu verbinden.

Möglich ist es auch, eine Öffnung über dem zweiten Sensorelement vorzusehen, die gegen den Innenraum abgedichtet ist und zusätzlich eine Öffnung durch den Deckel für das erste Sensorelement neben dem zweiten Sensorelement vorzusehen. Damit ist es möglich, den unterschiedlichen Empfindlichkeiten der beiden Sensorelemente gegenüber Feuchtigkeit unabhängig voneinander gerecht zu werden. So kann für das zweite Sensorelemente ein möglichst exponierter Zugang zur Außenluft geschaffen werden, um eine schnelle, unverfälschte Messung der Luftfeuchte zu ermöglichen. Der Drucksensor bzw. das erste Sensorelement dagegen kann mittels der oben bereits beispielhaft angeführten Maßnahmen gegen Feuchtigkeit geschützt werden.

In einer weiteren Ausführungsform ist das zweite Sensorelement in den Deckel eingebettet, was beispielsweise durch Laminieren erfolgen kann, wobei das zweite Sensorelement dann zusammen mit einer der Laminatlagen einlaminiert wird. Eine Öffnung zur aktiven Sensorfläche wird entweder nachträglich ausgebildet oder in Form einer strukturierten Laminatfolie von vornherein freigehalten.

Die Öffnung zum im Deckel integrierten zweiten Sensorelement kann von unten bzw. vom Hohlraum her erfolgen. Möglich ist es jedoch auch, die Öffnung nach oben hin direkt zur Umgebung vorzusehen.

Die einzelnen Gehäuseteile können unabhängig voneinander aus verschiedenen Materialien gefertigt sein. Bevorzugt sind Materialien, die auch zur Leiterplattenfertigung eingesetzt werden, insbesondere organische Laminate oder keramische Mehrschichtbauelemente. Bodenelement und Wandelement können integriert gefertigt sein. Möglich ist es jedoch auch, Bodenelement und Wandelement getrennt zu fertigen und erst anschließend miteinander elektrisch und mechanisch zu verbinden. Das Deckelelement wird vorzugsweise separat gefertigt.

Die Herstellung der Gehäuseteile kann vorzugsweise im Nutzen erfolgen, wobei mehrere Gehäuseteile parallel aus einem großflächigen Werkstück prozessiert werden können. Möglich ist es beispielsweise, mehrere Bodenelemente und vorzugsweise auch die Wandelemente auf einem ersten großflächigen Werkstück zu realisieren und auf einem zweiten Werkstück entsprechende Deckel parallel vorzufertigen. Auf die beiden Werkstücke werden dann jeweils die Sensorelemente an den entsprechenden Stellen aufgesetzt oder in diese einlaminiert und elektrisch kontaktiert. Anschließend werden die beiden Werkstücke elektrisch und mechanisch miteinander verbunden und gegebenenfalls abgedichtet.

Anschließend werden die durch die beiden Werkstücke verbundenen Sensorbauelemente vereinzelt. Dies kann beispiels¬weise durch Sägen oder jedes andere Trennverfahren erfolgen. Vorzugsweise können in zumindest einem der Werkstücke vorge¬fertigte Trennlinien erzeugt werden, an denen die Werkstücke bereits vor dem Verbinden mit dem jeweils anderen Werkstück zumindest teilweise durchtrennt sind, so dass der Ver¬einzelungs¬¬schritt sicherer geführt werden kann.

Alternativ können auch bereits vereinzelte und ggfs. funktionsgeprüfte Deckel auf noch im Verbund vorliegende Bodenelemente aufgesetzt werden. Die Vereinzelung erfolgt nach der Fertigstellung. Dies hat den Vorteil, dass der Hohlraum beim Vereinzeln bereits geschlossen ist.

Im Folgenden wird die Erfindung anhand von Ausführungs¬beispielen und den dazugehörigen Figuren näher erläutert. Weitere Beispiele zeigen Teilaspekte der Erfindung. Die Figuren sind zumindest teilweise nur schematisch und nicht maßstabsgetreu ausgeführt, so dass ihnen weder absolute noch relative Maßangaben zu entnehmen sind. Einzelne Teile können bis zur Anschaulichkeit auch vergrößert dargestellt sein. Gleiche oder gleichwirkende Teile sind mit den gleichen Bezugszeichen bezeichnet. Sind gleiche oder gleichwirkende Teile praktisch unverändert und daher klar erkennbar in mehreren Figuren vorhanden, so kann das Bezugszeichen auch der Figur oder den Figuren entnommen sein, in der das bezeichnete Teil zum ersten Mal auftaucht. Der besseren Übersichtlichkeit halber kann dann das entsprechende Bezugszeichen wegelassen sein.
Figur 1 zeigt ein erfindungsgemäßes Sensorbauelement im schematischen Querschnitt vor dem Aufsetzen des Deckels auf einen Verbund aus Wandelement und Bodenelement,
Figuren 2 bis 10 zeigen neun Ausführungsformen eines Sensorbauelements im schematischen Querschnitt,
Figur 11 zeigt eine mögliche Strukturierung eines im Nutzen hergestellten Deckels,
Figur 12 zeigt im schematischen Querschnitt die Herstellung eines Sensorbauelements und je einen Mehrfachnutzen für Bodenelement und Deckel.

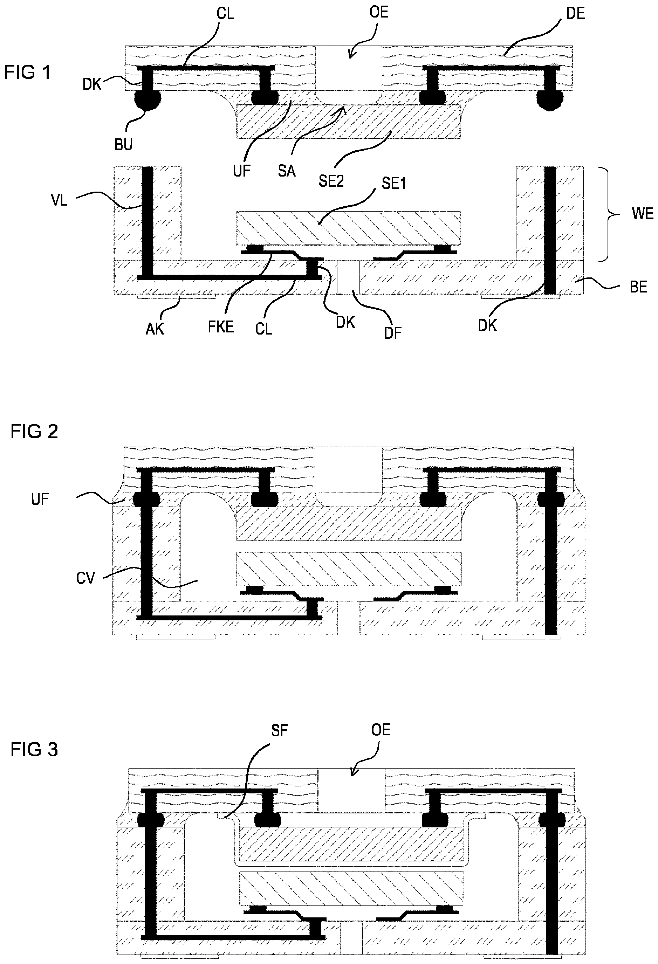

Figur 1 zeigt ein erfindungsgemäßes Sensorbauelement im schematischen Querschnitt während der Herstellung. Das Gehäuse weist drei Komponenten auf, nämlich ein flach ausge¬bildetes Bodenelement BE, ein rahmenförmig ausgebildetes Wandelement WE und einen ebenfalls flachen Deckel DE. Das Wand¬element WE ist vorzugsweise integriert mit dem Boden¬element BE oder dem Deckel DE gefertigt. In der Figur ist das Wandelement WE fest mit dem Bodenelement verbunden, kann integriert mit diesem gefertigt sein oder nachträglich auf dem Bodenelement BE aufgebracht sein. Möglich ist es jedoch auch, das Wandelement integriert mit dem Deckel DE zu fertigen.

In der Figur bilden Bodenelement BE und Wandelement WE eine Wanne, auf deren Boden innen das erste Sensorelement SE1 montiert ist. Die elektrische und mechanische Verbindung zwischen dem ersten Sensorelement SE1 und dem Bodenelement BE, beziehungsweise dessen inneren elektrischen Anschlussflächen erfolgt über Federkontakt-elemente FKE. Diese sind als lang gestreckte Blattfedern ausgebildet, die mit einem Ende auf dem Bodenelement BE aufsitzen und deren anderes Ende mit Kontaktflächen des ersten Sensorelements SE1 verbunden ist.

Die inneren Anschlussflächen des Bodenelements BE können als flächige Metallisierungen ausgeführt sein. Möglich ist es jedoch auch, eine Durchkontaktierung DK zu verwenden, auf deren Stirnfläche das Federkontaktelement FKE direkt elektrisch leitend aufgebondet oder zum Beispiel aufgelötet werden kann. Auch die Verbindung zwischen Federkontaktelement FKE und Kontaktflächen des ersten Sensorelements SE1 erfolgt über eine Lotverbindung, beispielsweise einen Bump.

Das Federkontaktelement FKE kann auch in einem additiven Prozess (z.B. mittels Lithografie und Galvanik) direkt an Ort und Stelle strukturiert werden.

Innerhalb des Bodenelements BE ist zumindest eine vergrabene Metallisierungsebene vorgesehen, die strukturiert ist und so eine Verdrahtungsebene CL darstellt. Die Verdrahtungsebene CL ist über Durchkontaktierungen DK mit inneren Anschlussflächen des Gehäuses auf der Oberseite des Bodenelements BE, mit auf der Unterseite des Bodenelements BE aufgebrachten Außenkontakten AK sowie mit Verbindungsleitungen VL innerhalb des Wandelements WE verbunden.

Der Deckel DE weist ebenfalls zumindest eine Verdrahtungsebene CL auf. Diese ist mittels Durchkontaktierungen DK mit auf der Unterseite des Deckels angeordneten Kontaktflächen verbunden.

Wenn hier und im Folgenden Begriffe wie oben und unten oder Unterseite und Oberseite verwendet werden, so bezieht sich das auf die in den Figuren dargestellte Anordnung, die aber für die Funktion des Sensorbauelements keine Rolle spielt, ebenso wenig für die spätere Anordnung in einer Schaltungs¬umgebung. Unten liegende Außenkontakte AK sind dann zur Montage des Sensorbauelements zum Beispiel "auf" einer Leiterplatte geeignet.

Auf der Unterseite des Deckels DE ist ein zweites Sensorelement SE2 montiert und elektrisch leitend mit dem Deckel verbunden. Dazu ist es beispielsweise mittels Lotverbindungen auf innere Anschlussflächen, oder auf die innen mündenden Durchkontaktierungen innerhalb des Deckels DE aufgelötet. Somit ist das zweite Sensorelement SE2 elektrisch und mechanisch mit dem Deckel DE verbunden. Über die Verdrahtungsebene und gegebenenfalls weitere Durchkontaktierungen ist das zweite Sensorelement SE2 mit den Verbindungsleitungen VL innerhalb des Wandelements WE verbindbar. Dazu kann wie dargestellt auf der Unterseite des Deckels ein entsprechendes Lotdepot zur Verbindung mit dem Wandelement WE vorgesehen sein.

Der Spalt zwischen dem zweiten Sensorelement SE2 und der Unterseite des Deckels DE ist mit einer Unterfüllmasse UF gefüllt, beispielsweise einem flüssig applizierbaren Harz. Vorzugsweise werden Kapillarkräfte innerhalb des Spalts zwischen zweitem Sensorelement SE2 und Deckel DE ausgenutzt, um eine Verteilung der Unterfüllmasse UF zu ermöglichen.

Durch den Deckel DE hindurch ist eine Öffnung vorgesehen, unterhalb der die Oberfläche des zweiten Sensorelements SE2 freiliegt. In diesem Bereich ist die aktive Sensorfläche SA angeordnet, die somit über die Öffnung OE in Verbindung mit der innerhalb des Sensorbauelements herrschenden Atmosphäre steht.

Die Öffnung OE ist vorzugsweise vor der Montage des zweiten Sensorelements SE2 auf den Deckel DE vorgefertigt, kann aber auch nach der Montage des zweites Sensorelements SE2 auf dem Deckel DE erzeugt werden. Auf jeden Fall ist die Öffnung OE vor dem Einbringen der Unterfüllmasse UF fertiggestellt, so dass die im Bereich der Öffnung OE fehlenden Kapillarkräfte dafür sorgen, dass die aktive Sensorfläche SA von der Unterfüllmasse OF unbedeckt bleibt.

Figur 2 zeigt die in der Figur 1 getrennt dargestellten Teile nach dem Verbinden des Deckels DE mit dem Wandelement WE. Die elektrische und mechanische Verbindung erfolgt über eine Lotstelle SC, so dass das zweite Sensorelement SE2 über entsprechende Verbindungsleitungen VL mit Außenkontakten AK verbunden ist. Über die Verbindungsleitungen VL kann auch das erste Sensorelement SE1 mit dem zweiten Sensorelement SE2 verbunden sein. Dies ist insbesondere dann von Vorteil, wenn das zweite Sensorelement SE2 einen ASIC umfasst, der auch für das erste Sensorelement SE1 Sensorfunktionen beziehungsweise Auswertung von detektierten Messwerten und Generierung eines Ausgabesignals übernimmt.

Nach der Montage des Deckels DE auf das Wandelement WE kann der Spalt zwischen Deckel und Wandelement wieder mit einer Unterfüllmasse UF ausgefüllt werden, wobei wiederum die Kapillarkräfte zwischen Deckel DE und Wandelementen WE für eine Verteilung der Unterfüllmasse UF sorgen. Durch die Abdichtung ist ein Hohlraum CV innerhalb des Gehäuses ein¬geschlossen. Lediglich eine Durch¬führung DF im Bodenelement BE unterhalb des ersten Sensor¬elements SE1 sorgt für eine Verbindung des Hohlraums CV mit der äußeren Umgebung des Sensorbauelements. Über diese Durch¬führung kann ein Luft- und Druckaustausch stattfinden, der es dem ersten Sensorelement SE1 erlaubt, die entsprechen¬den Parameter der äußeren Umgebung zu messen.

Figur 3 zeigt ein zweites Ausführungsbeispiel der Erfindung im schematischen Querschnitt. Im Unterschied zum ersten Ausführungsbeispiel gemäß der Figuren 1 und 2 ist hier das zweite Sensorelement SE2 gegen den Deckel DE nicht mit einer Unterfüllmasse UF abgedichtet. Vielmehr ist das zweite Sensorelement SE2 nach der Montage auf der Innenseite des Deckels DE mittels Auflöten durch eine Schutzfolie SF gegen den Deckel DE abgedichtet. Die Schutzfolie schließt das gesamte zweite Sensorelement SE2 von unten ein und dichtet gegen den Deckel DE ab. Auf diese Weise wird verhindert, dass über die Öffnung OE im Deckel DE ein Luftaustausch mit dem Hohlraum CV zwischen Deckel DE, Wandelement WE und Bodenelement BE erfolgen kann. Der einzige Zugang zum Hohlraum CV erfolgt wie bisher über eine Durchführung DF im Bodenelement BE unterhalb des ersten Sensorelements SE1.

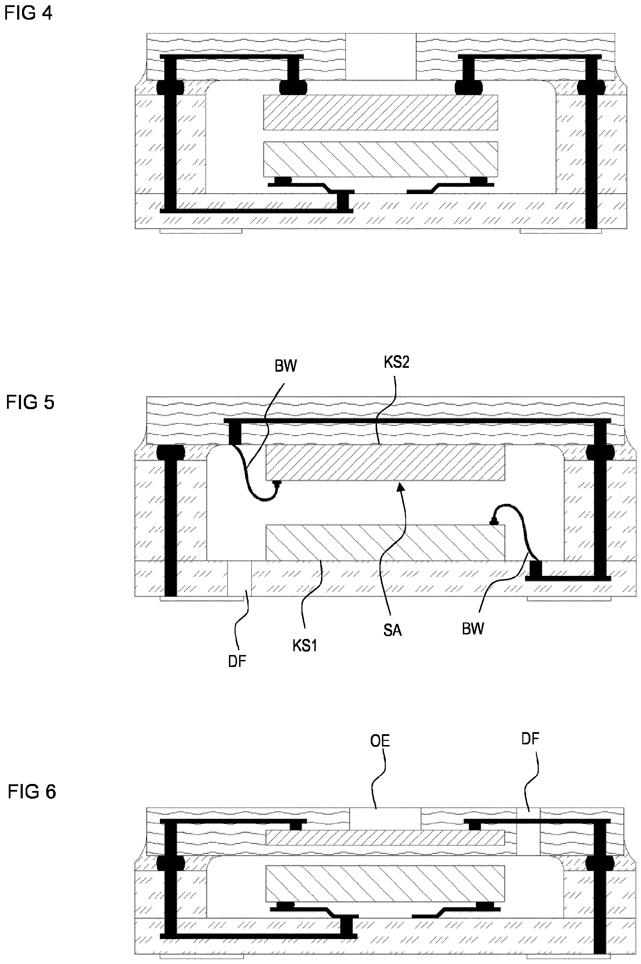

Figur 4 zeigt ein viertes Beispiel eines Sensor-Bauelements im schema¬ti-schen Querschnitt. Im Unterschied zum zweiten und dritten Ausführungsbeispiel ist hier der Hohlraum CV über einen Spalt GP zwischen Deckel DE und zweiten Sensorelement SE2 durch die Öffnung mit der Außenluft verbunden. Die Öffnung OE stellt die einzige Verbindung des Hohlraums nach außen dar, so dass darüber ein Luftaustausch und damit ein Druckausgleich erfolgt, der die Bestimmung der entsprechenden Parameter der Außenluft ermöglicht. Eine weitere Durchführung für das erste Sensorelement ist hier nicht vorgesehen.

Figur 5 zeigt im schematischen Querschnitt ein Sensor-Bauelement eines vierten Beispiels, das sich durch eine andere Montage der beiden Sensorelemente SE1, SE2 auszeichnet. In diesem Bei¬spiel ist eines, vorzugsweise wie dargestellt die beiden Sensorelemente jeweils durch Aufkleben mittels einer Kleb¬stoffschicht KS1, KS2 mit dem Bodenelement BE beziehungsweise dem Deckel DE verbunden. Die Klebstoffschicht dient allein der mechanischen Befestigung. Elektrische Ver¬bindung zwischen den Sensorelementen und den Verdrahtungs¬ebenen und damit mit den Außenkontakten erfolgt über Bonddrähte BW die beispiels¬weise den nach oben weisenden Kontaktflächen des ersten Sensorelements SE1 mit inneren Anschlussflächen des Bodenelements BE verbinden beziehungsweise nach unten weisende Kontaktflächen des zweiten Sensorelements SE2 mit nach unten weisenden Anschlussflächen des Deckels DE verbinden.

Im Bodenelement ist ein Durchführung DF neben dem ersten Sensorelement SE2 angebracht, die eine Verbindung zum Hohlraum CV schafft. Eine weitere Verbindung zur Außenluft, insbesondere für das zweite Sensorelement SE2 ist nicht vorgesehen. In diesem Ausführungsbeispiel weist die aktive Sensorfläche SA des zweiten Sensorelements nach unten. Dadurch können beide Sensorelemente SE auf dasselbe Luftvolumen zugreifen und unterschiedliche Parameter innerhalb dieses Volumens bestimmen.

Figur 6 zeigt ein fünftes Beispiel eines Sensor-bauelement im schematischen Querschnitt. Im Unterschied zum ersten Ausführungsbeispiel gemäß der Figuren 1 und 2 ist hier das zweite Sensorelement SE2 innerhalb des Deckels DE einge¬bettet und nur durch eine nach oben weisende Öffnung mit der Oberseite des Deckels DE beziehungsweise der Außenluft ver¬bunden. Die nach unten weisende unterste Schicht des Deckels DE isoliert das zweite Sensorelement SE2 gegenüber dem Hohlraum CV. In dem Fall ist eine Durchführung DF in den Hohlraum vorgesehen, die hier in der Figur 6 durch den Deckel DE geführt ist. Möglich ist es jedoch auch, die Durchführung DF durch das Bodenelement zu führen.

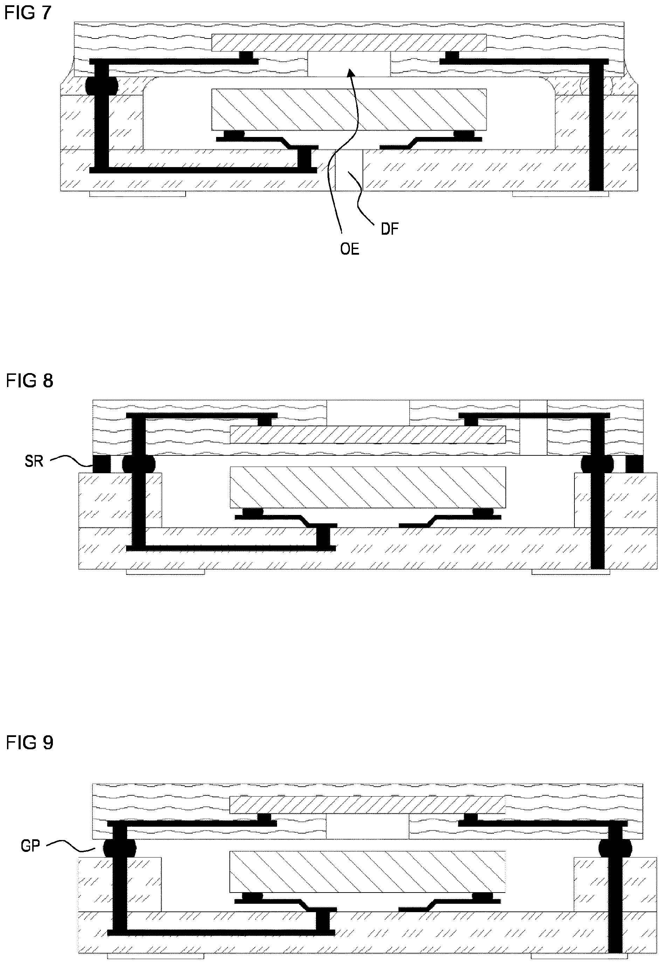

Figur 7 zeigt im schematischen Querschnitt ein Sensor-Bauelement sechste Beispiels, bei dem das zweite Sensorelement SE2 wie im fünften Beispiel ebenfalls im Deckel DE versenkt ist. Im Unterschied zum vorigen Ausführungsbeispiel weist die Öffnung OE nach unten, so dass die aktive Sensorfläche SA durch die Öffnung OE mit dem Hohlraum CV im Inneren des Gehäuses verbunden ist. Der Hohlraum CV ist über eine Durchführung DF durch das Bodenelement BE mit der Außenluft verbunden, so dass die zu bestimmenden Parameter im Inneren des Hohlraums CV über erstes und zweites Sensorelement detektiert werden können.

In den Figuren 8 - 11 werden im Folgenden Gehäuse vorgestellt, die für die Sensorkombinationen Druck-/Feuchtesensor bzw. Druck-/Temperatursensor die jeweils optimalen Voraussetzungen für die beiden derart unterschiedlichen Sensoren bieten. Von der Bodenseite her schützen die Kavität und die stressentkoppelnden Federstrukturen den Drucksensor gegen Stress. Ein eigener Zugang für die Meßgröße "Druck" ermöglicht es, den Drucksensor separat gegen Feuchte zu schützen. Der deckelseitig angeordnete und ins Substrat eingebettete Feuchtesensor bietet dagegen eine optimal exponierte Meßfäche. Der Zugang für die Meßgröße "Luftfeuchte" ist dabei auf einer dem Zugang für die Meßgröße "Druck" gegenüberliegenden Gehäuseaußenfäche angeordnet.

Figur 8 zeigt ein siebtes Beispiel eines Sensor-Bauelements im schemati-schen Querschnitt. Dieses entspricht im Wesentlichen dem in Figur 6 dargestellten fünften Ausführungsbeispiel mit dem Unterschied, dass zwischen Deckel DE und Wandelement WE keine abdichtende Unterfüllmasse vorgesehen ist. Zur Abdichtung des Hohlraums CV ist dafür zwischen Deckel DE und Wandelement WE ein Dichtungsring SR vorgesehen, der im Randbereich vom Deckel DE beziehungsweise Wandelement WE angeordnet ist und den Hohlraum CV vollständig abdichtet. Eine Verbindung des ersten Sensorelements SE1 beziehungsweise des Hohlraums CV mit der Außenluft erfolgt über eine Durchführung DF, die hier im Deckel DE vorgesehen ist, aber ebenso im Bodenelement BE vorgesehen sein kann.

Weiterhin ist es möglich, den hier dargestellten Dichtungs¬ring SR alternativ auch in den anderen Ausführungsbeispielen einzusetzen.

Figur 9 zeigt ein achtes Beispiel im schematischen Querschnitt. Dieses ist ähnlich wie das sechste in Figur 7 dargestellte Beispiel ausgebildet mit dem Unterschied, dass auch hier die Unterfüllmasse UF zwischen Deckel DE und Wandelement WE weggelassen ist. Der Hohlraum CV innerhalb des Gehäuses bleibt dadurch unabgedichtet, so dass durch den entsprechenden Spalt GP zwischen Deckel DE und Wandelement WE und zwischen den Lotstellen hindurch eine Verbindung zum Hohlraum verbleibt, die erstes und zweites Sensorelement SE1, SE2 mit der Außenluft verbinden. Eine weitere Öffnung oder Durchführung ist nicht erforderlich.

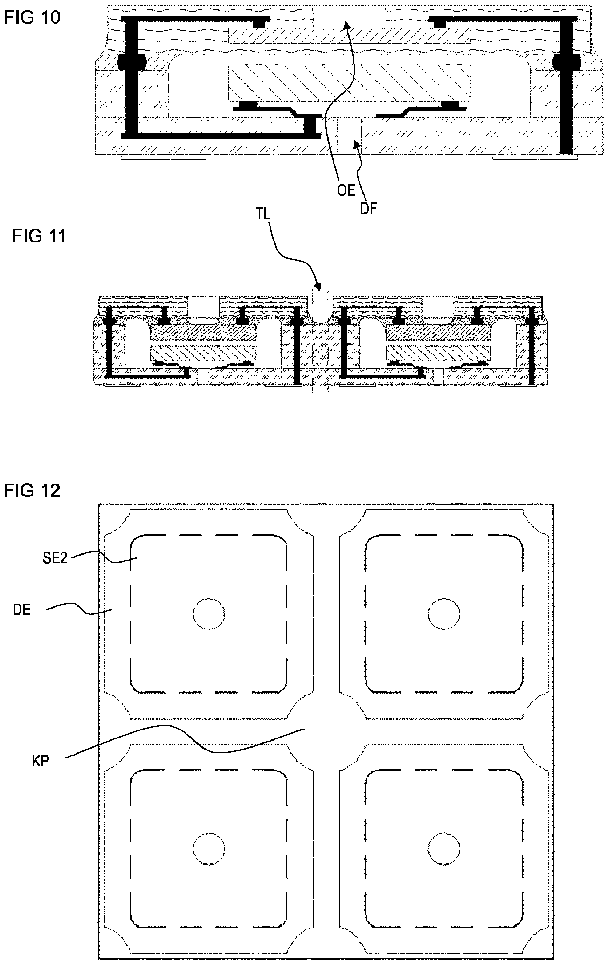

Figur 10 zeigt ein neuntes Beispiel im schemati¬schen Querschnitt. Hier ist das zweite Sensorelement SE2 innerhalb des Deckels DE vergraben und mit der Außenluft über eine nach oben geführte Öffnung OE verbunden. Der Hohlraum CV ist über eine Durchführung DF unterhalb des ersten Sensor¬elements SE1 mit der Außenluft verbunden. Im Übrigen ist der Hohlraum durch eine Unterfüllmasse UF oder eine andere wie oben beschriebene Maßnahme abgedichtet.

Zur einfacheren Herstellung des erfindungsgemäßen Sensorbauelements kann in einem Mehrfachnutzen gearbeitet werden. Dieser bietet sich insbesondere für das Bodenelement BE an. In einem größeren Werkstück werden dazu Bodenelemente BE mit entsprechenden Wandelementen WE verbunden, so dass ein regelmäßiges Raster von späteren Einzelbauelementen auf dem gemeinsamen Mehrfachnutzen entsteht. Bodenelemente BE und Wandelemente WE werden dann weiter prozessiert wie es anhand von Figur 1 und im ersten Ausführungsbeispiel beschrieben ist. Auf den Mehrfachnutzen mit Bodenelementen und Wand¬elementen können nun einzelne Deckel DE für die Einzelbau¬elemente aufgesetzt werden. Möglich ist es jedoch auch, auch den Deckel DE als Mehrfachnutzen auszuführen und als groß-flächige Einheit auf den ersten Mehrfachnutzen mit Boden- und Wandelementen aufzusetzen.

Auch der Mehrfachnutzen für den Deckel DE ist wie ein Einzel¬deckel fertig prozessiert und mit zweiten Sensorelementen SE2 bestückt. Diese können wie im Ausführungsbeispiel von Figur 11 dargestellt unterhalb des Deckels DE montiert sein. Möglich ist es jedoch auch, Mehrfachnutzen für den Deckel zu verwenden, in die zweite Sensorelemente integriert sind.

Nach dem Aufsetzen des Mehrfachnutzens für den Deckel DE können die Hohlräume der Einzelbauelemente in einem Schritt abgedichtet werden, beispielsweise durch Applizieren der Unterfüllmasse. Dies kann wieder durch Ausnutzen von Kapillarkräften im Fügespalt zwischen Mehrfachnutzen für Deckel und Mehrfachnutzen für Wand- und Bodenelemente erfolgen. Dazu muss im Deckel an zumindest einer Stelle, vorzugsweise jedoch im Bereich zwischen jeweils zwei benachbarten Deckeln für einzelne Bauelemente ein Zugang zum Spalt geschaffen werden, beispielsweise durch Bohren oder Sägen durch den Deckel.

Das Applizieren der Unterfüllmasse kann erleichtert werden, wenn der Mehrfachnutzen für den Deckel eine einfachere Verteilung der Unterfüllmasse erlaubt. In Figur 12 ist ein Beispiel für eine Strukturierung des Mehrfachnutzens für den Deckel dargestellt, die auch dem Schnittbild der Figur 11 entspricht. Dazu wird der horizontale Spalt GP zwischen Deckel und Wandelement von oben entlang von Trennlinien TL zwischen jeweils zwei Reihen und zwischen jeweils zwei Spalten durch ein geeignetes Verfahren wie beispielsweise Sägen, Ätzen oder Laserstrukturierung geöffnet. Ein Sägeverfahren bietet sich an, da ein Endpunkt für die Strukturierung durch den Spalt gegeben ist, sobald dieser geöffnet ist. An den Kreuzungspunkten KP, wo sich vertikale und horizontale Trennlinien TL kreuzen, werden im Mehrfachnutzen für den Deckel großflächigere Aussparungen vorgesehen, in die dann die Unterfüllmasse durch Dispensen oder Pin-Transfer einfach eingebracht werden kann. Durch Kapillarkräfte verteilt sich die Unterfüllmasse dann in den Bereichen, wo zweites Sensorelement und Deckel überlappen und nur durch den engen Spalt getrennt sind, der die entsprechende Kapillarwirkung entfachen kann.

In der Figur 12 entspricht die Überlappfläche mit Kapillarwirkung der von der gestrichelten Linie eingeschlossenen Fläche, die der oberen Oberfläche des zweiten Sensorelements SE2 entspricht abzüglich der Öffnung OE im Deckel, in der die Oberseite des Sensorelements freigelegt ist und in der aufgrund des fehlenden Spaltes auch keine Kapillarkräfte wirken.

Nach dem Abdichten der Hohlräume CV aller Sensorbauelemente im Mehrfachnutzen und nach Aushärten der Unterfüllermasse werden die einzelnen Sensorbauelemente aus dem Mehrfachnutzen durch Auftrennen vereinzelt. Dies kann ebenfalls wieder durch Schneiden, Fräsen, Lasern oder Sägen entlang der Trennlinien erfolgen.

Obwohl das Verfahren zur Herstellung der Sensorbauelemente mittels Mehrfachnutzen nur für eine Ausführungsform dargestellt wurde, so sind doch die meisten Ausführungsformen ebenfalls dazu geeignet, im Mehrfachnutzen durchgeführt zu werden. Da dies mit erheblichen Verfahrenserleichterungen verbunden ist, ist das Arbeiten im Mehrfachnutzen bei der Herstellung der Sensorbauelemente bevorzugt.

Bei dieser Verfahrensweise kann es auch vorteilhaft sein, einzelne Schritte, die für das Einzelbauelement in der angegebenen günstigen Reihenfolge durchgeführt werden, im Mehrfachnutzen in einer anderen Reihenfolge durchzuführen. Beispielsweise ist es möglich, Öffnungen und Durchführungen erst in einem späteren Schritt einzubringen. Parallel dazu ist es auch möglich, entlang der Trennlinien TL im Mehrfachnutzen für den Deckel Trennlinien vorzufertigen und beispielsweise dazu Gräben in den Mehrfachnutzen für den Deckel zu erzeugen, die den Deckel nicht vollständig durchbrechen, so dass er noch als einheitliches Gebilde also als Mehrfachnutzen auf den Nutzen für Boden- und Wandelemente aufgesetzt werden kann. Dies erleichtert insbesondere das Öffnen der Spalte, da dazu weniger Material abzutragen ist und das Eindringen von Partikeln oder Gasen in den Hohlraum vor dem Einbringen der Unterfüllmasse vermieden werden kann.

Die in den Figuren dargestellten Ausführungsbeispiele und Ausführungsformen unterscheiden sich teilweise nur in wenigen Details. Die Erfindung ist jedoch nicht auf die dargestellten Kombinationen von Details beschränkt. Vielmehr ist es möglich, anhand einzelner Ausführungsbeispiele beschriebene Details auch bei anderen Ausführungsbeispielen einzusetzen, beziehungsweise einzelne Merkmale und Details in neuen Ausführungsbeispielen anders zu kombinieren. Die Erfindung ist daher nicht auf die in den Figuren dargestellten Ausführungsbeispiele beschränkt.

### Begriffs- und Bezugszeichenliste

- SE1, SE2: erstes und zweites Sensorelement Gehäuse, aufweisend
- BE: Bodenelement
- WE: rahmenförmig ausgebildetes Wandelement und
- DE: Deckel
- CV: Hohlraum im Gehäuse ASIC mit
- SA: aktiver Sensorfläche, Teil von SE2
- AK: elektrische Außenkontakte am Gehäuse MEMS Sensor (erstes Sensorelement) mit
- FKE: Federkontaktelementen
- DF: Durchführung im Gehäuse für MEMS Sensor
- KS: Klebstoffschicht
- UF: Unterfüllmasse
- OE: Öffnung für das zweite Sensorelement
- DK: Durchkontaktierung
- VL: Verbindungsleitung
- BU: Bump
- CL: Verdrahtungsebene
- SC: Lotverbindung
- SF: Abdeck- oder Schutzfolie
- GP: Spalt zwischen DE und SE2
- SR: Dichtungsring
- KP: Kreuzungspunkt

## Patentansprüche

1. Sensor-Bauelement
- mit einem ersten und einem zweiten Sensorelement (SE1,SE2) für jeweils eine Sensorfunktion
- mit einem Gehäuse, das ein Bodenelement (BE), ein rahmenförmig ausgebildetes Wandelement (WE) und einen Deckel (DE) aufweist, die zusammen einen Hohlraum (CV) einschließen
- bei dem das erste Sensorelement (SE1) ein MEMS Sensor ist und im Inneren des Hohlraums auf dem Bodenelement des Gehäuses montiert ist
- bei dem das zweite Sensorelement (SE2) als ASIC mit einer aktiven Sensorfläche (SA) ausgebildet und auf oder unter dem Deckel montiert oder im Deckel eingebettet ist
- bei dem der oben liegende Deckel (DE) eine Öffnung (OE) ausweist
- bei dem die aktive Sensorfläche (SA) des zweiten Sensorelements (SE2) durch die Öffnung mit der Außenluft außerhalb des Gehäuses verbunden ist
- bei dem elektrische Außenkontakte (AK) an einer Außenfläche des Gehäuses vorgesehen sind
- bei dem der Hohlraum zumindest eine Durchführung (DF) aufweist, die das Innere des Gehäuses und damit den MEMS Sensor mit der Umgebung außerhalb des Gehäuses verbindet
- bei dem der MEMS Sensor (SE1) verspannungsfrei auf Federkontaktelementen (FKE) montiert ist, die die Kontaktflächen des MEMS Sensors mit inneren Anschlussflächen auf der Innenseite des Bodenelements verbinden bei dem auf oder in dem ASIC zumindest eine Sensorfunktion integriert ist und bei dem der ASIC einen Ausgabewert generiert.

2. Sensor-Bauelement nach Anspruch 1 ,
bei dem das erste Sensorelement (SE1) ein MEMS Drucksensor ist.

3. Sensor-Bauelement nach einem der Ansprüche 1 bis 2,
bei dem der Deckel (DE) eine Leiterplatte mit einer integrierten Verschaltung umfasst,
bei dem die elektrische Verbindung zwischen dem ASIC auf der Leiterplatte und den elektrischen Außenkontakten (AK) innerhalb des Wandelements (WE) und durch das Bodenelement (BE) hindurch verläuft.

4. Sensor-Bauelement nach einem der Ansprüche 1 bis 3,
- bei dem der oben liegende Deckel (DE) eine Öffnung (OE) ausweist,
- bei dem die aktive Sensorfläche (SA) des zweiten Sensorelements (SE2) unterhalb der Öffnung angeordnet ist.

5. Sensor-Bauelement nach einem der Ansprüche 1 bis 4,
bei dem das zweite Sensorelement (SE2) die Öffnung (OE) im Deckel (DE) von unten verschließt,
- indem das zweite Sensorelement mit einem Klebstoff von unten auf den Deckel geklebt ist oder
- indem das zweite Sensorelement im Abstand unten am Deckel befestigt ist und der Raum zwischen der Oberseite des zweiten Sensorelements und der Unterseite des Deckels zumindest entlang der Kanten des zweiten Sensorelements mit einer Unterfüllmasse aufgefüllt ist
- wobei die aktive Sensorfläche (SA) frei von Klebstoff oder Unterfüllmasse (UF) ist.

6. Sensor-Bauelement nach einem der Ansprüche 1 bis 5,
bei dem der Deckel (DE) mit Abstand auf dem Wandelement (WE) befestigt ist, so dass als Durchführung (DF) ein Spalt (GP) zwischen Deckel und Wandelement gebildet ist.

7. Sensor-Bauelement nach einem der Ansprüche 1 bis 6,
bei dem das zweite Sensorelemente (SE2) ein Temperatur- und/oder ein Feuchtesensor ist.

8. Sensor-Bauelement nach Anspruch 7,
bei dem das erste Sensorelement (SE1) ein Drucksensor ist,
bei dem erstes und zweites Sensorelement unterschiedliche Zugänge zur Umgebung aufweisen, wobei der Zugang für das erste Sensorelement (SE1) mittels einer Schutzmaßnahme gegen Feuchtigkeit geschützt ist, wobei durch den Zugang für das zweite Sensorelement (SE2) ein ungehinderter Zutritt von Feuchtigkeit zur aktiven Sensorfläche des zweiten Sensorelements ausgebildet ist.

## Claims

1. Sensor component
- having a first and a second sensor element (SE1, SE2) for a respective sensor function,
- having a housing that has a base element (BE), a wall element (WE) in the form of a frame and a cover (DE), which together enclose a cavity (CV),
- in which the first sensor element (SE1) is an MEMS sensor and is mounted inside the cavity on the base element of the housing,
- in which the second sensor element (SE2) is in the form of an ASIC having an active sensor area (SA) and is mounted on or under the cover or embedded in the cover,
- in which the cover (DE) situated at the top has an opening (OE),
- in which the active sensor area (SA) of the second sensor element (SE2) is connected through the opening to the outside air outside the housing,
- in which electrical outer contacts (AK) are provided on an outer area of the housing,
- in which the cavity has at least one bushing (DF) that connects the inside of the housing and hence the MEMS sensor to the surroundings outside the housing,
- in which the MEMS sensor (SE1) is mounted without tension on spring contact elements (FKE) that connect the contact areas of the MEMS sensor to inner pads on the inside of the base element, in which at least one sensor function is integrated on or in the ASIC and in which the ASIC generates an output value.

2. Sensor component according to Claim 1,
in which the first sensor element (SE1) is an MEMS pressure sensor.

3. Sensor component according to one of Claims 1 and 2,
in which the cover (DE) comprises a printed circuit board having an integrated circuitry,
in which the electrical connection between the ASIC on the printed circuit board and the electrical outer contacts (AK) runs within the wall element (WE) and through the base element (BE) .

4. Sensor component according to one of Claims 1 to 3,
- in which the cover (DE) situated at the top has an opening (OE),
- in which the active sensor area (SA) of the second sensor element (SE2) is arranged beneath the opening.

5. Sensor component according to one of Claims 1 to 4,
in which the second sensor element (SE2) closes the opening (OE) in the cover (DE) from below
- by virtue of the second sensor element being adhesively bonded onto the cover by means of an adhesive from below or
- by virtue of the second sensor element being secured to the bottom of the cover at an interval, and the space between the top of the second sensor element and the bottom of the cover being filled with an underfill compound at least along the edges of the second sensor element,
- wherein the active sensor area (SA) is free of adhesive or underfill compound (UF).

6. Sensor component according to one of Claims 1 to 5,
in which the cover (DE) is secured on the wall element (WE) at an interval, so that a gap (GP) is formed as a bushing (DF) between cover and wall element.

7. Sensor component according to one of Claims 1 to 6,
in which the second sensor element (SE2) is a temperature sensor and/or a moisture sensor.

8. Sensor component according to Claim 7,
in which the first sensor element (SE1) is a pressure sensor,
in which the first and second sensor elements have different accesses to the surroundings, wherein the access for the first sensor element (SE1) is protected against moisture by means of a protective measure,
wherein the access for the second sensor element (SE2) produces unimpeded admittance of moisture to the active sensor area of the second sensor element.

## Revendications

1. Composant capteur
- comprenant un premier et un deuxième élément capteur (SE1, SE2) respectivement pour une fonction de capteur,
- comprenant un boîtier qui possède un élément de fond (BE), un élément de paroi (WE) réalisé en forme de cadre et un couvercle (DE), lesquels entourent ensemble un espace creux (CV),
- avec lequel le premier élément capteur (SE1) est un capteur MEMS et est monté à l'intérieur de l'espace creux sur l'élément de fond du boîtier,
- avec lequel le deuxième élément capteur (SE2) est réalisé sous la forme d'un ASIC avec une surface de capteur (SA) active et est monté sur ou sous le couvercle ou est incorporé dans le couvercle,
- avec lequel le couvercle (DE) qui se trouve en haut possède une ouverture (OE),
- avec lequel la surface de capteur (SA) active du deuxième élément capteur (SE2) est reliée à l'air extérieur à l'extérieur du boîtier à travers l'ouverture,
- avec lequel des contacts extérieurs (AK) électriques se trouvent sur une surface extérieure du boîtier,
- avec lequel l'espace creux possède au moins une traversée (DF) qui relie l'intérieur du boîtier, et ainsi le capteur MEMS, avec l'environnement à l'extérieur du boîtier,
- avec lequel le capteur MEMS (SE1) est monté sans contraintes sur des éléments de contact à ressort (FKE) qui relient les surfaces de contact du capteur MEMS avec des surfaces de raccordement internes sur le côté intérieur de l'élément de fond,
- avec lequel au moins une fonction de capteur est intégrée sur ou dans l'ASIC et avec lequel l'ASIC génère une valeur de sortie.

2. Composant capteur selon la revendication 1, avec lequel le premier élément capteur (SE1) est un capteur de pression MEMS.

3. Composant capteur selon l'une des revendications 1 à 2,
- avec lequel le couvercle (DE) comporte un circuit imprimé avec un câblage intégré,
- avec lequel la liaison électrique entre l'ASIC sur le circuit imprimé et les contacts extérieurs (AK) électriques passe à l'intérieur de l'élément paroi (WE) et à travers l'élément de fond (BE).

4. Composant capteur selon l'une des revendications 1 à 3,
- avec lequel le couvercle (DE) qui se trouve en haut possède une ouverture (OE),
- avec lequel la surface de capteur (SA) active du deuxième élément capteur (SE2) est disposée au-dessous de l'ouverture.

5. Composant capteur selon l'une des revendications 1 à 4,
avec lequel le deuxième élément capteur (SE2) ferme l'ouverture (OE) dans le couvercle (DE) par le dessous,
- en ce que le deuxième élément capteur est collé par le dessous sur le couvercle avec un adhésif ou
- en ce que le deuxième élément capteur est fixé à un espacement donné sur le dessous du couvercle et l'espace entre le côté supérieur du deuxième élément capteur et le côté inférieur du couvercle est rempli d'une masse de remplissage par le dessous au moins le long des bords le deuxième élément capteur,
- la surface de capteur (SA) active étant exempte d'adhésif ou de masse de remplissage par le dessous (UF) .

6. Composant capteur selon l'une des revendications 1 à 5,
avec lequel le couvercle (DE) est fixé à un écart donné sur l'élément de paroi (WE), de sorte que la traversée (DF) formée est un interstice (GP) entre le couvercle et l'élément de paroi.

7. Composant capteur selon l'une des revendications 1 à 6,
avec lequel le deuxième élément capteur (SE2) est un capteur de température et/ou d'humidité.

8. Composant capteur selon la revendication 7, avec lequel le premier élément capteur (SE1) est un capteur de pression,
avec lequel le premier et le deuxième élément capteur présentent des accès différents à l'environnement, l'accès pour le premier élément capteur (SE1) étant protégé contre l'humidité au moyen d'une mesure de protection,
un accès sans entraves de l'humidité vers la surface de capteur active du deuxième élément capteur étant formé à travers l'accès pour le deuxième élément capteur (SE2) .
